# EUROPEAN PATENT APPLICATION

(11) **EP 4 687 374 A1**
(43) Date of publication of application: **04.02.2026**
(21) Application number: 25188970.5
(22) Date of filing: 11.07.2025
(51) Int. Cl.: H05K 1/02, H01T 4/08, H05K 1/11

(54) **PRINTED CIRCUIT BOARD (PCB) ASSEMBLY FOR ELECTROSTATIC DISCHARGE (ESD) PROTECTION**

(30) Priority: 01.08.2024 IN 202421058439
(71) Applicant: Vertiv Corporation, Westerville, OH 43082 (US)
(72) Inventor: Mukherjee, Kajal, 723151 Purulia (IN); Raut, Dilesh Arvind, 410507 Talegaon Dabhade (IN)
(74) Representative: Cousens, Nico

(57) **Abstract**

A printed circuit board (PCB) assembly for electrostatic discharge (ESD) protection is disclosed. The assembly includes a top layer comprising at least one signal track and configured to support at least a portion of a plurality of electronic components mounted thereon. A middle layer disposed beneath the top layer. The middle layer comprises at least one ground tack configured to receive electrostatic discharge currents from adjacent layers. A bottom layer disposed beneath the middle layer. The bottom layer comprising at least one power track and configured to support another portion of the plurality of electronic components. A plurality of metal discharge elements disposed on at least one of the top layer or the bottom layer. Each of the metal discharge element is electrically connected to the at least ground track of the middle layer.

## Description

### FIELD

The present disclosure relates to the field of electrostatic discharge (ESD) protection. More specifically, it pertains to a printed circuit board (PCB) assembly incorporating metal discharge elements to protect electronic components mounted on the PCB from ESD events.

### BACKGROUND

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches, which in and of themselves may also correspond to implementations of the claimed technology.

Electrostatic discharge (ESD) is a sudden release of energy between objects with different charges that can pose a threat to electronic devices due to the build-up of static electricity. The rapid release of energy between two objects with different potential charges, usually by air and contact discharge, is known as ESD. ESD testing is an electromagnetic compatibility (EMC) immunity test that is designed to ensure that products can operate without deterioration when exposed to the quick release of energy of an electrostatic event.

ESD can result from various sources, including lightning strikes, electrostatic build-up in the environment, and human interaction. Lightning strikes are a severe source of ESD, as they can generate extremely high voltage and current pulses. When lightning strikes near an electronic device or its connected infrastructure, the resulting ESD can travel through power lines, communication cables, and other conductive paths. For example, a lightning strike near a data centre can induce high-voltage surges that penetrate the power supply units, damaging servers, storage devices, and networking equipment. This can lead to data loss, system downtime, and costly repairs or replacements. In an electrostatic build-up occurs when static electricity accumulates on the surface of materials due to friction, separation, or environmental conditions such as low humidity. This build-up can lead to unexpected ESD events when the charged object comes into contact with a conductive path. When an object or a person accumulates static charge from their surroundings and comes into contact with a conductive edge, such as those on printed circuit boards (PCBs), a potential difference is created. Further, when an object or a person accumulates static charge from their surroundings and comes into contact with a conductive edge, such as those on PCBs, a potential difference is created. If this potential difference is large enough, there can be a conductive path for the current, creating a massive current pulse. As the current pulse develops, high heat can be dissipated within the components and the conductors on the PCB itself. At extreme field strengths and developed currents, the PCBs can be damaged and electronic components placed on the PCB can be destroyed. These ESD events can damage integrated circuits (ICs) at various stages during manufacturing and assembly to end-user interaction.

Therefore, there exists a need for an improved PCB design incorporating structural elements that efficiently divert and dissipate electrostatic charges, protecting electronic components and improving overall system reliability.

### OBJECTIVE

An object of the disclosure is to provide a printed circuit board (PCB) assembly that offers effective electrostatic discharge (ESD) protection by integrating metal discharge elements that capture and divert ESD energy away from sensitive electronic components.

Another objective of the disclosure is to enhance the reliability and longevity of PCB-mounted electronic components by minimizing the detrimental effects of ESD events during manufacturing, handling, or end-use.

Yet another objective of the disclosure is to introduce a PCB assembly wherein metal discharge elements are electrically connected to an internal ground track and strategically placed to intercept and dissipate ESD energy.

Yet another object of the present disclosure is to provide a cost-effective solution that eliminates the need for traditional ESD suppression techniques, enhancing circuit robustness with minimal design complexity.

### SUMMARY

The summary is provided to introduce aspects related to a printed circuit board assembly for electrostatic discharge protection, and the aspects are further described below in the detailed description. This summary is not intended to identify essential features of the claimed subject matter, nor is it intended for use in determining or limiting the scope of the claimed subject matter.

The present disclosure relates to a printed circuit board (PCB) assembly for electrostatic discharge (ESD) protection. The PCB assembly may include a top layer that may include at least one signal track and configured to support at least a portion of a plurality of electronic components mounted thereon. The PCB assembly may further include a middle layer disposed beneath the top layer. The middle layer may include at least one ground track configured to receive electrostatic discharge currents from adjacent layers. The PCB assembly may further include a bottom layer disposed beneath the middle layer. The bottom layer may include at least one power track and configured to support another portion of the plurality of components. The PCB assembly may further include a plurality of metal discharge elements disposed on at least one of the top layer or the bottom layer. Each of the metal discharge elements is electrically connected to the at least one ground track of the middle layer. Each of the metal discharge elements is configured to capture and divert electrostatic discharge (ESD) away from the plurality of electronic components by providing an alternative conductive path to the at least one ground track of the middle layer.

Each of the metal discharge elements has a geometry selected from a group consisting of: star-shaped, cross-shaped, zigzag-shaped, circular rings, squared rings, T-shaped bridges, cone-shaped.

The metal discharge elements may be disposed in unoccupied areas of the at least one of the top layer or the bottom layer of the PCB assembly.

The metal discharge elements may be formed of a conductive metal material selected from a group consisting of: copper, gold-plated copper, tin-plated copper, alloys thereof.

The metal discharge elements may include pointed geometries for efficient charge capture and dissipation.

The plurality of metal discharge elements may be positioned proximate to the edges of the PCB assembly to server as initial points of contact during an ESD event.

The PCB assembly may include a plurality of metal wires and vias electrically interconnecting the top layer, the middle layer, and the bottom layer.

The plurality of metal wires and the vias electrically couple the metal discharge elements to the at least one ground track in the middle layer.

The metal discharge elements are configured to provide ESD protection for contact discharges of up to 4 kV and air discharges of up to 8 kV.

The metal discharge elements are arranged on at least one of the top layer or the bottom layer to form a shielding barrier between potential ESD sources and the electronic components, thereby protecting active areas of the PCB assembly from ESD events.

Other aspects and advantages of the disclosure will become apparent from the following description, taken in conjunction with the accompanying drawings, illustrating by way of example, the principles of the disclosure.

### BRIEF DESCRIPTION OF THE DRAWINGS

The accompanying drawings constitute a part of the description and are used to provide further understanding of the present disclosure. The drawings illustrate exemplary embodiments of the present disclosure and, together with the description, serve to explain the principles of the present disclosure.
**Figure 1** illustrates a perspective view of a printed circuit board (PCB) assembly, having metal discharge elements.
**Figure 2** illustrates a top view of the PCB assembly showing the placement of metal discharge elements on the top layer.
**Figure 3** illustrates a bottom view of the PCB assembly showing the placement of metal discharge elements on the bottom layer.
**Figures 4A to 4F** illustrate various geometrical configurations of metal discharge elements.

A more complete understanding of the present disclosure and its embodiments thereof may be acquired by referring to the following description and the accompanying drawings.

### LIST OF REFERENCE NUMERALS

100 - Printed Circuit Board (PCB)
102 - Metal discharge elements
104 - Top Layer
104a - Signal track disposed on the top layer
106 - Middle Layer
106a - Ground track disposed on the middle layer
108 - Bottom Layer
108a - Power track disposed on the bottom layer
112 - Vias
114 - Electronic components mounted on at least one of the top layer or the bottom layer

### DESCRIPTION

The description set forth below in connection with the appended drawings is intended as a description of various embodiments of the present disclosure and is not intended to represent the only embodiments in which the present disclosure may be practiced. Each embodiment described in this disclosure is provided merely as an example or illustration of the present disclosure, and should not necessarily be construed as preferred or advantageous over other embodiments. The description includes specific details for the purpose of providing a thorough understanding of the present disclosure. However, it will be apparent to those skilled in the art that the present disclosure may be practiced without these specific details. In the drawings, like numbers refer to like elements.

It is to be noted, however, that the reference numerals used herein illustrate only typical embodiments of the present subject matter, and are therefore, not to be considered for limiting its scope, for the subject matter may admit to other equally effective embodiments.

The specification may refer to "an", "another", "one" or "some" embodiment(s) in several locations.

This does not necessarily imply that each such reference is to the same embodiment(s), or that the feature only applies to a single embodiment. Single features of different embodiments may also be combined to provide other embodiments.

As used herein, the singular forms "a", "an" and "the" are intended to include the plural forms as well, unless expressly stated otherwise. It will be further understood that the terms "include", "comprises", "including" and/or "comprising" when used in this specification, specify the presence of stated features, integers, steps, operations, elements, and/or components, but do not preclude the presence or addition of one or more other features, integers, steps, operations, elements, components, and/or groups thereof. It will be understood that when an element is referred to as being "connected" or "coupled" to another element, it can be directly connected or coupled to the other element or intervening elements may be present. Furthermore, "connected" or "coupled" as used herein may include operatively connected or coupled. As used herein, the term "and/or" includes any and all combinations and arrangements of one or more of the associated listed items.

Unless otherwise defined, all terms (including technical and scientific terms) used herein have the same meaning as commonly understood by one of ordinary skills in the art to which this disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The detailed description includes specific details for the purpose of providing a thorough understanding of the present disclosure. However, it will be apparent to those skilled in the art that the present disclosure may be practiced without these specific details.

The present disclosure will now be described in greater detail with reference to the accompanying drawings, which illustrate preferred embodiments of a printed circuit board (PCB) assembly for electrostatic discharge (ESD) protection. These drawings, together with the description, serve to exemplify and not limit the scope of the disclosure.

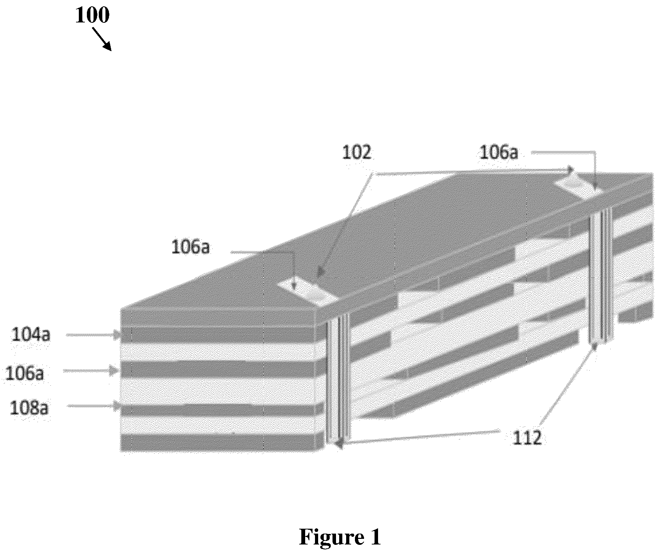

Referring now to **Figure 1**, a perspective view of a printed circuit board (PCB) assembly **100**, having metal discharge elements **102**, is illustrated. The PCB assembly is shown as comprising a top layer **104**, a middle layer **106**, and a bottom layer **108** stacked vertically to form a multilayer structure. Also depicted a plurality of metal discharge elements **102** disposed on at least one of the top layer **104** or the bottom layer **106** of the PCB assembly **100**, and one or more vias **112** extending between the top layer **104**, the middle layer **106**, and the bottom layer **108.** The vias **112** are conductive through-holes formed within the PCB assembly **100** to establish vertical electrical connectivity between different layers of the board. Specifically, in the disclosed embodiment, the vias **112** connect the metal discharge elements **102** located on the top layer **104** and/or the bottom layer **108.** These vias are typically filled or plated with conductive material, such as copper, and serve as low-resistance pathways for redirecting captured electrostatic discharge (ESD) energy to the internal ground plane.

The top layer **104** may include one or more signal tracks **104a** and may be configured to support at least a portion of a plurality of electronic components **114** mounted thereon. These electronic components **114** may include, but is not limited to, integrated circuits, resistors, capacitors, or other passive elements that are sensitive to electrostatic discharge. The middle layer **106**, disposed beneath the top layer **104**, may include one or more ground tracks **106a** and may be configured to receive electrostatic discharge currents from adjacent layers (i.e., the top layer **104** and the bottom layer **108**) of the PCB assembly **100.** The bottom layer **108** disposed beneath the middle layer **106**, and may include one or more power tracks **108a** and may be further configured to support another portion of the electronic components **114.** Each of the top layer **104**, the middle layer **106**, and the bottom layer **108** may be electrically interconnected by a plurality of metal wires (not shown) and vias **112**, which facilitate electrical continuity across the layered structure.

In this embodiment, the plurality of metal discharge elements **102** are disposed on at least one of the top layer **104** or the bottom layer **108.** Each of the metal discharge elements **102** may be electrically connected to the one or more ground tracks **106a** of the middle layer **106**, for example via the vias **112**, and may be configured to capture and divert electrostatic discharge (ESD) away from the electronic components **114** by providing an alternative conductive path terminating at the one or more ground tracks **106a.** This configuration enhances the ESD immunity of the PCB assembly **100** by ensuring that ESD energy is dissipated before it can reach sensitive areas of the PCB assembly **100.**

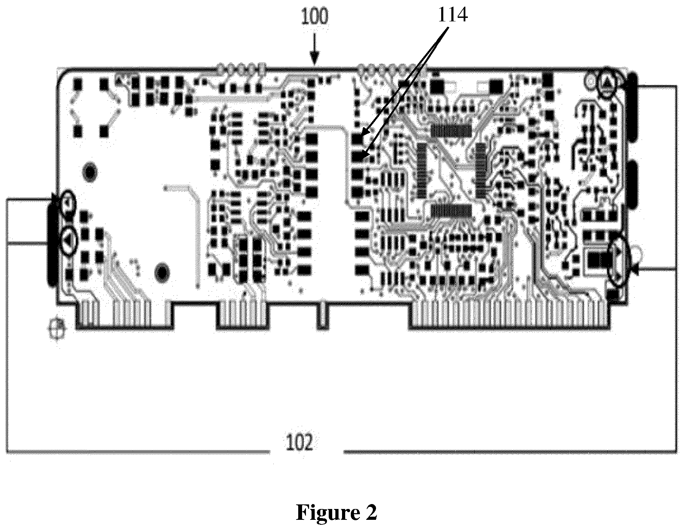

Referring now to **Figure 2**, a top view of the PCB assembly **100** showing the placement of the plurality of metal discharge elements **102** on the top layer **104**, is illustrated. A portion of the plurality of electronic components **114**, such as integrated circuits and surface-mounted devices, are also shown mounted on the top layer **104**, occupying active regions of the PCB assembly **100.** The placement of the metal discharge elements **102** relative to the electronic components **114** is such that the discharge elements **102** are positioned in unoccupied areas of the top layer **104** and may be distributed to provide effective electrostatic discharge (ESD) protection.

As illustrated, the metal discharge elements **102** are positioned near the periphery and intermediate regions of the top layer **104**, forming a protective barrier between potential ESD sources and the sensitive electronic components **114.** Each metal discharge element **102** is electrically coupled, via internal interconnections including the vias **112** and the metal wires (not shown), to the one or more grounding tracks **106a** located in the middle layer **106.** This arrangement enables the metal discharge elements **102** to capture and divert ESD energy before it reaches the one or more signal-carrying signal tracks **104a** or any of the critical functional elements of the PCB assembly **100.** The layout as shown in **Figure 2** illustrates how ESD protection is integrated directly into the physical structure of the PCB assembly **100** to provide localized shielding for sensitive electronic regions within the PCB assembly **100.**

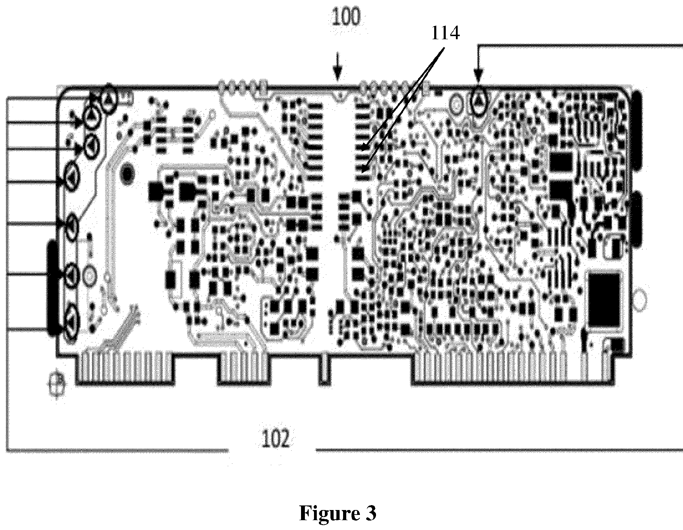

Referring now to **Figure 3**, a bottom view of the PCB assembly **100** showing the placement of the plurality of metal discharge elements **102** on the bottom layer **108**, is illustrated. This bottom-side arrangement of the metal discharge elements **102** enables additional or redundant protection against ESD events originating from contact surfaces opposite to the top layer **104.** This view further shows another portion of the electronic components **114** mounted on the bottom layer **108.**

Each of the metal discharge elements **102** disposed on the bottom layer **108** is physically and electrically coupled to the one or more ground tracks **106a** embedded in the middle layer **106** via the vias **112**, the metal wires, and or other conductive structures that electrically link the metal discharge elements **102** to the one or more ground tracks **106a** of the middle layer **106.** This structure provides a low-impedance discharge path that safely routes ESD energy to the one or more ground tracks **106a**, bypassing the one or more signal tracks **104a** and the electronic components **114** mounted elsewhere on the PCB assembly **100.**

The metal discharge elements **102** are fabricated from conductive metal materials, such as copper, or optionally copper plated with gold or tin to improve conductivity and corrosion resistance. As shown in **Figure 3**, the metal discharge element **102** are strategically positioned in the unoccupied or peripheral areas of the bottom layer **108**, particularly along the outer edges of the PCB assembly **100.** This strategic placement ensures that the metal discharge elements **102** serve as initial points of contact for any incoming electrostatic energy, thereby forming an effective shielding barrier that protects active circuit regions from ESD damage.

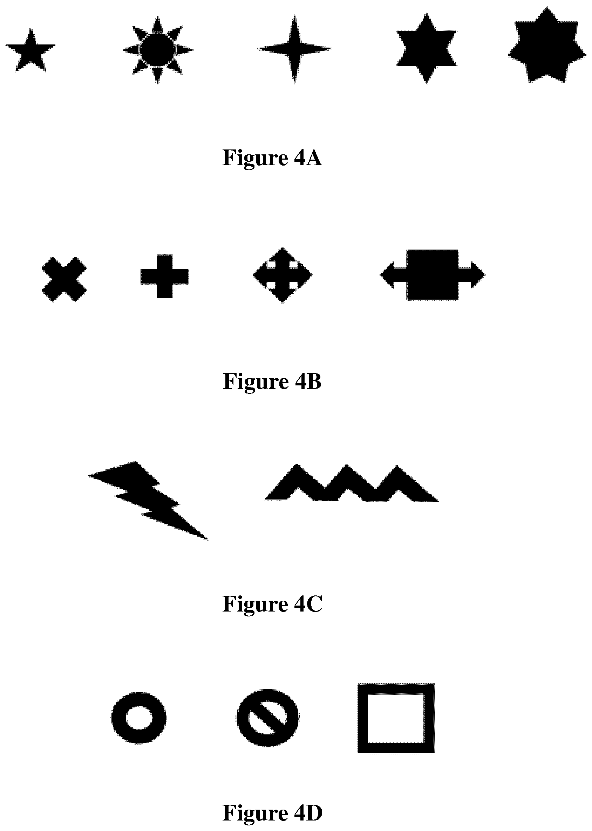

Referring now to **Figures 4A to 4F**, various geometrical configurations of the metal discharge elements **102**, are illustrated. These figures represent example embodiments in which the geometry of the metal discharge elements **102** is selected to enhance electrostatic discharge (ESD) capture and dissipation efficiency. The shape of each discharge elements **102** plays a critical role in determining the surface area, electric field distribution, and current path characteristics, thereby influencing the overall effectiveness of the PCB assembly **100** in mitigating ESD-induced damage. As illustrated in **Figures 4A to 4F**, a variety of metal discharge element **102** can be employed, depending on the layout of the PCB assembly **100** and application-specific ESD requirements.

**In** **Figure 4A****,** a set of star-shaped metal discharge elements **102** is depicted. These geometries may include multiple sharp radial arms extending from a central hub. The pointed protrusions are configured to intensify the local electric field and enhance the ability of the metal discharge element **102** to attract and capture incoming electrostatic charges. The extended surface area provided by each radial arm increases the contact interface with ESD events and assists in rapid dissipation toward the one or more ground tracks **106a** via the internal conductive path.

**Figure 4B** shows a variety of cross-shaped metal discharge elements **102**, which include perpendicular intersecting arms cantered at a node. These configurations are suitable for symmetrical current redirection. In such implementations, conductive bridges may be formed using solder material in a cross pattern, where each intersecting arm aids in dispersing ESD energy away from sensitive electronic components **114** and directing it toward grounded structures.

In **Figure 4C****,** Zigzag-shaped metal discharge elements **102** are illustrated. These geometries are designed to increase the path length available for current dissipation, thereby reducing the concentration of discharge at any single point. In zigzag shaped discharge elements, strips are formed by creating a series of sharp bends in a metal solder strip. The zigzag pattern/shaped discharge elements increase the surface area for ESD dissipation and creates a longer path for the current to follow, reducing the likelihood of it reaching sensitive areas.

**Figure 4D** illustrates ring-shaped metal discharge elements **102,** including both circular and square variants. These configurations are typically placed around sensitive traces or components to act as ESD shields. Circular or square metal ring discharge elements are designed to surround sensitive components or traces, creating a protective barrier. The circular shape provides a continuous path for the ESD current to follow, preventing it from passing through the protected area.

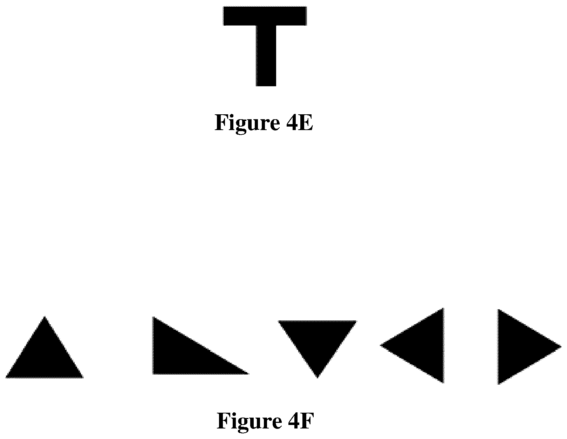

**In** **Figure 4E****,** a T-shaped bridge metal discharge element **102** is depicted. T-shaped solder bridge metal discharge element connects conductive traces or zones with a simple grounding arm. The bridge discharge elements consist of a horizontal arm intersecting with a vertical arm, resembling the letter "T". They are effective in redirecting ESD currents away from sensitive components and ensuring proper grounding.

**Figure 4F** presents cone-shaped metal discharge elements **102,** which are characterized by tapered triangular forms with their pointed apexes. Cone-shaped metal discharge element features a tapered geometry for concentrated charge collection and rapid dissipation to ground. The structures feature a tapered design, resembling a cone, with a pointed tip. The cone shape of the discharge elements efficiently captures and redirects ESD energy away from sensitive components, offering a focused and directed approach to ESD protection. The gradual incline of the cone enhances the dissipation of electrical energy, minimizing the risk of damage to critical areas. These solder shapes of metal discharge elements with increased surface area and/or jagged edges help disperse the discharge, reducing its intensity and minimizing the risk of damage. These shapes not only enhance the discharge efficiency but also improve electromagnetic compatibility (EMC) of the PCB assembly **100.**

In an exemplary operational scenario, when an electrostatic discharge (ESD) event occurs such as when a charged human body or conductive object comes into contact with the surface or edge of the printed circuit board (PCB) assembly **100,** the discharge typically enters through exposed conductor paths or peripheral regions. In such instances, the plurality of metal discharge elements **102,** disposed on at least one of the top layer **104** or the bottom layer **108,** serve as the initial points of contact. Due to their pointed geometries, high conductivity, and strategic positioning near the outer edges or unoccupied areas of the PCB assembly **100,** the metal discharge elements **102** attract and capture the incident electrostatic energy.

Each metal discharge element is electrically connected to the one or more ground tracks **106a** located within the middle layer **106** through the metal wires and the vias **112.** This connection forms a low-impedance discharge path from the surface of the PCB assembly to the internal grounding structure. Upon contact with the ESD surge, the discharge current is rapidly diverted through the metal discharge elements **102** and routed via the metal wires and the vias **112** to the one or more ground tracks **106a.** As a result, the electrostatic energy is safely dissipated within the ground lane, thereby bypassing sensitive electronic components **114** that are mounted on one or both of the top layer **104** and the bottom layer **108.**

This configuration allows the PCB assembly **100** to withstand contact discharges of up to 4 kilovolts (kV) and air discharges of up to 8 kV, in accordance with standard ESD compliance testing. The distributed placement and geometric variation of the metal discharge elements **102** from a multi-point ESD protection matrix that enhances overall robustness. Rather than relying on a single central ground or external shielding solution, this distributed design enables uniform dissipation of electrostatic energy across the entire PCB surface. This approach minimizes the risk of component-level failure and improves both the electromagnetic compatibility (EMC) and long-term reliability of the PCB assembly **100** in high-voltage environments.

Thus, the disclosed PCB assembly **100** overcomes the limitation of conventional ESD protection mechanisms by integrating a layered ESD mitigation structure directly into the PCB architecture. Unlike conventional mechanisms that rely on discrete components or external shielding mechanisms, the present disclosure incorporates a plurality of metal discharge elements **102** into the top layer **104** and/or the bottom layer **108** of the PCB assembly. Each of the plurality of metal discharge elements **102** is directly connected to the one or more ground tracks **106a** in the middle layer **106.** This structure forms a distributed and embedded ESD protection matrix that intercepts, redirects, and neutralizes electrostatic discharge energy before it reaches sensitive signal and power circuitry.

A key technical advantage of the disclosed PCB assembly **100** lies in the low-impedance vertical discharge paths formed by the metal wires and the vias **112,** which link the metal discharge elements **102** to the one or more ground tracks **106a.** This internalized grounding architecture ensures that surface-level electrostatic charge is immediately transferred to a safe discharge plane, thereby reducing the probability of ESD-induced component failure. Additionally, the inclusion of geometrically optimized discharge elements, such as star-shaped, cross-shaped, and zigzag-shaped variants further enhances field capture efficiency and current dispersion, leading to improved protection effectiveness under diverse ESD conditions.

Furthermore, the disclosed PCB assembly **100** offers improved design flexibility and spatial efficiency by allowing the discharge elements **102** to be placed in unoccupied or peripheral areas of the PCB surface, including regions that do not interfere with component placement or routing density. This avoids the need for additional board real estate or external metal shielding. By distributing the ESD protection throughout the PCB surface, the disclosure eliminates centralized vulnerabilities and enables modular, scalable protection adaptable to a variety of PCB layouts and form factors.

The embedded nature of the ESD mitigation architecture also contributes to enhanced electromagnetic compatibility (EMC) by stabilizing voltage differentials and reducing unintended emissions during discharge events. The disclosed structure supports ESD compliance levels up to 4 kV (contact) and 8 kV (air), making it particularly suitable for use in consumer electronics, industrial controllers, automotive systems, and other environments where high-voltage transients are common. The combination of layered architecture, distributed discharge elements, and internalized grounding paths yields a technically robust, compact, and manufacturable solution to ESD protection challenges.

It is to be understood that the aspects and embodiment of the disclosure described above may be used in any combination with each other. Several of the aspects and embodiment may be combined together to form a further embodiment of the disclosure.

This does not necessarily imply that each such reference is to the same embodiment(s), or that the feature only applies to a single embodiment. Single features of different embodiments may also be combined to provide other embodiments.

As used herein, the terms "includes", "comprises", "including" and/or "comprising" when used in this specification, specify the presence of stated features, operations, elements, and/or components, but do not preclude the presence or addition of one or more other features, steps, operations, elements, components, and/or groups thereof. It will be understood that when an element is referred to as being "connected" or "coupled" to another element, it can be directly connected or coupled to the other element or intervening elements may be present. Furthermore, "connected" or "coupled" as used herein may include operatively connected or coupled. As used herein, the term "and/or" includes any and all combinations and arrangements of one or more of the associated listed items.

Unless otherwise defined, all terms (including technical and scientific terms) used herein have the same meaning as commonly understood by one of ordinary skills in the art to which this disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

## Claims

1. A printed circuit board "PCB" assembly (100) for electrostatic discharge "ESD" protection, comprising:
a top layer (104) comprising at least one signal track (104a) and configured to support at least a portion of a plurality of electronic components (114) mounted thereon;
a middle layer (106) disposed beneath the top layer (104), wherein the middle layer (106) comprises at least one ground track (106a) configured to receive electrostatic discharge currents from adjacent layers;
a bottom layer (108) disposed beneath the middle layer (106), wherein the bottom layer (108) comprises at least one power track (108a) and configured to support another portion of the plurality of electronic components (114);
a plurality of metal discharge elements (102) disposed on at least one of the top layer (104) or the bottom layer (108),
wherein each of the metal discharge elements (102) is electrically connected to the at least one ground track (106a) of the middle layer (106), and
wherein each of the metal discharge elements (102) is configured to capture and divert ESD away from the plurality of electronic components (114) by providing an alternative conductive path to the at least one ground track (106a) of the middle layer (106).

2. The PCB assembly (100) as claimed in claim 1, wherein each of the metal discharge elements (102) has a geometry selected from a group consisting of: star-shaped, cross-shaped, zigzag-shaped, circular rings, squared rings, T-shaped bridges, cone-shaped.

3. The PCB assembly (100) as claimed in claim 1 or 2, wherein the metal discharge elements (102) are disposed in unoccupied areas of at least one of the top layer (104) or the bottom layer (108) of the PCB assembly (100).

4. The PCB assembly (100) as claimed in any preceding claim, wherein the metal discharge elements (102) are formed of a conductive metal material selected from a group consisting of: copper, gold-plated copper, tin-plated copper, alloys thereof.

5. The PCB assembly (100) as claimed in any preceding claim, wherein the metal discharge elements (102) comprise pointed geometries for efficient charge capture and dissipation.

6. The PCB assembly (100) as claimed in any preceding claim, wherein the plurality of metal discharge elements (102) are positioned proximate to the edges of the PCB assembly (100) to serve as initial points of contact during an ESD event.

7. The PCB assembly (100) as claimed in any preceding claim, wherein the PCB assembly (100) comprises:
a plurality of metal wires and vias (112) electrically interconnecting the top layer (104), the middle layer (106), and the bottom layer (108).

8. The PCB assembly (100) as claimed in claim 7, wherein the plurality of metal wires and the vias (112) electrically couple the metal discharge elements (102) to the at least one ground track (106a) in the middle layer (106).

9. The PCB assembly (100) as claimed in any preceding claim, wherein the metal discharge elements (102) are configured to provide ESD protection for contact discharges of up to 4 kV and air discharges of up to 8 kV.

10. The PCB assembly (100) as claimed in any preceding claim, wherein the metal discharge elements (102) are arranged on at least one of the top layer (104) or the bottom layer (108) to form a shielding barrier between potential ESD sources and the electronic components (114), thereby protecting active areas of the PCB assembly (100) from ESD events.
